# EUROPÄISCHE PATENTANMELDUNG

(11) **EP 1 933 341 A2**
(43) Veröffentlichungstag der Anmeldung: **18.06.2008**
(21) Anmeldenummer: 07020361.7
(22) Anmeldetag: 18.10.2007
(51) Int. Cl.: H01F 27/29, H01F 27/02, H01F 17/04

(54) **Induktives SMD-Bauteil**

(30) Priorität: 11.12.2006 DE 102006058336
(71) Anmelder: Vacuumschmelze GmbH & Co. KG, 63450 Hanau (DE)
(72) Erfinder: Hundt, Harald, 64807 Dieburg (DE); Heumann, Dirk, Dr., 63450 Nidderau (DE)
(74) Vertreter: Schmuckermaier, Bernhard

(57) **Zusammenfassung**

Ein SMD-Bauteil (19) (SMD: surface-mounted device) umfasst ein induktives Element (1) in einem Gehäuse (17, 25). Das induktive Element (1) weist zwei elektrische Anschlüsse (13,14) auf, die zu einer Seite eines Gehäuses (17, 25) aus dem Gehäuse (17, 25) extern kontaktierbar herausgeführt sind. Zusätzlich zu den elektrischen Anschlüssen (13, 14) ist ein gegenüber dem induktiven Element (1) fixiertes Abstützelement (15, 24, 29, 30) am Bauteil (19) vorgesehen ist. Das von dem induktiven Element (1) wegführende Ende des Abstützelementes (15, 24, 29, 30) bildet mit den aus dem Gehäuse (17, 25) herausgeführten Enden der elektrischen Anschlüsse (13, 14) eine Montagefläche ausserhalb des Gehäuses (17, 25).

## Beschreibung

Die Erfindung betrifft ein induktives SMD-Bauteil (SMD: surface mounted device) mit einem induktiven Element in einem Gehäuse, und eine Anordnung aus einer elektrischen Leiterplatte und dem induktiven SMD-Bauteil.

In vielen Bereichen der Elektronik hat die SMT-Technologie (surface-mounting technology) als Oberflächenmontagetechnik für elektrische Bauteile auf Leiterplatten die konventionelle Art der Bestückung von elektronischen Elementen in der PTH-Technologie (pin through hole) abgelöst. Gemäß der früher üblichen Technologie wurden Anschlussdrähte von elektronischen Bauteilen durch eine Leiterplatine hindurch geführt und auf der Gegenseite verlötet.

SMD-Bauteile werden nur einseitig auf die Anschlussflächen einer Leiterplatte gelötet, wodurch Material eingespart und die Baugröße von elektronischen Schaltungen verringert wird. Zusätzlich kann eine Leiterplatte beidseitig bestückt werden. Im Gegensatz zur PTH-Technik ist vor der Herstellung einer Lotverbindung zwischen einem SMD-Bauteil und der SMT-Leiterplatte das SMD-Bauteil auf der Leiterplatte nicht fixiert, wobei eine sichere Positionierung des SMD-Bauteils allein über die Kontaktfläche des Anschlusses des SMD-Bauteils und der SMT-Leiterplatte nicht gewährleistet ist. Aufgrund der beschränkten SMT-Kontaktfläche je Anschluss ergibt sich insbesondere bei einer Drossel mit nur zwei elektrischen Anschlüssen an ihren Enden bisher das Problem, dass dieses aufwändig auf einer Leiterplatte positioniert werden muss, um zuverlässig verlötet werden zu können.

Der vorliegenden Erfindung liegt die Aufgabe zugrunde, ein für die SMT-Montage geeignetes und mit geringem Aufwand sicher positionierbares induktives Bauteil mit zwei elektrischen Anschlüssen bereitzustellen, , sowie eine Anordnung mit einem solchen Bauteil und einer Leiterplatte.

Die Aufgabe wird dadurch gelöst, dass in dem Bauteil zusätzlich zu zwei vorhandenen Anschlüssen eines induktiven Elementes ein relativ zum induktiven Element fixiertes Abstützelement am Bauteil vorgesehen ist. Das von dem induktiven Element wegführende Ende des Abstützelementes bildet hierbei mit den Enden der elektrischen Anschlüsse eine Montagefläche ausserhalb des Bauteiles. Als Montageebene des Bauelementes wird die Ebene angesehen, die nach der SMT-Montage durch die dem Bauteil zugewandte Seite der zu kontaktierenden Leiterplatte gebildet wird. Als induktive Elemente können neben Spulen mit magnetischen Kernen Luftspulen, bewickelte Folien, Streifenleiter etc. verwendet werden.

Ein Aspekt der Erfindung ist, dass die Auflagebereiche der Anschlussenden auf der Leiterplatte nicht in einer Linie liegen, sondern ein Dreieck bilden, gleich wie viele elektrische Anschlüsse vorhanden sind. Bei lediglich zwei elektrischen Anschlüssen würde ohne das Vorhandensein eines Abstützelementes die Positionierung des Bauteiles auf einer SMT-Leiterplatte schwierig, da das Bauelement drohen würde, umzufallen. Auch mehr als zwei Anschlusselemente können ungünstig für die Standfestigkeit des Bauteiles sein, beispielsweise wenn die Anschlusselemente in einer Linie angeordnet sind. Auch in diesem Fall kann das zusätzliche Vorsehen eines Abstützelementes außerhalb dieser Linie zum Aufspannen einer Montagefläche sinnvoll sein.

Bei flächiger Ausbildung der Auflagebereiche ist es günstig, wenn alle Auflagebereiche möglichst koplanar zu der definierten Montagefläche ausgerichtet sind. Es kann aber auch vorgesehen sein, dass die Auflagebereiche nicht flächig, sondern jeweils mit einer der Leiterplatte zugewandten Spitze oder Kante ausgebildet sind, um durch den derart jeweils gebildeten spitz zulaufenden Zwischenraum zwischen dem Auflagebereich und der Leiterplatte einen Raum zu bilden, in den durch die Oberflächenspannung flüssiger Lotwerkstoff hineingesaugt wird.Auch in diesen Fall ist es vorteilhaft, mittels eines Abstützelementes eine definierte Position des SMD-Bauteiles auf einer Leiterplatte zu ermöglichen.

Zum Befestigen des Bauteiles auf einer Leiterplatte kann ein Kleber oder eine Lötpaste verwendet werden, die vor dem Aufbringen des Bauteiles beispielsweise mittels eines Siebdruckverfahrens oder durch Aufbringen mittels eines dünnen Röhrchens platziert werden. Danach wird beispielsweise mittels eines programmierbaren Bestückungsautomaten ein Bauteil aufgesetzt und danach dieses unter Wärmezufuhr leitend mit der Leiterplatte verbunden. Die verwendete Lötpaste enthält typischerweise eine Mischung aus einem Flussmittel und sehr kleinen Lötmittelkügelchen.

Zur Verlötung von SMD-Bauteilen sind verschiedene Lötverfahren bekannt, wobei besonders das Reflow-Lötverfahren günstig einzusetzen ist. Die Verlötung sorgt sowohl für eine elektrische als auch für eine mechanische Verbindung.

Als ein weiteres Problem bei der Verarbeitung von SMD-Bauteilen, das durch die Erfindung gelöst wird, hat sich das sogenannte Tombstoning herausgestellt, bei dem Bauteile im Rahmen ihrer Verlötung durch asymmetrische Wirkung der Oberflächenspannung des verflüssigten Lötzinns einer Kraft unterworfen werden, die das entsprechende Bauteil aus der Leiterplattenebene herauskippt und zu nicht kontaktierten Anschlüssen führt.

Tendenziell wirkt das Vorsehen von zusätzlichen Abstützstellen für ein Bauteil einer solchen Kippbewegung entgegen. Wird zusätzlich das Abstützelement mit seinem Auflagebereich auch mit der Leiterplatte verlötet, so wirkt auch dies gegen eine Verkippung des Bausteins stabilisierend.

Eine Ausgestaltung der Erfindung liegt darin, dass das Abstützelement aus einem elektrisch leitenden Werkstoff besteht. Zusätzlich kann auch der Auflagebereich des Abstützelementes an der Oberfläche der Leiterplatte, wie oben ausgeführt, verlötbar sein. Dazu kann das Abstützelement ebenso wie die elektrischen Anschlüsse beispielsweise aus einem elektrisch leitenden Draht bestehen, der zur Ausbildung von Auflagebereichen an seinem Ende abgebogen sein kann. Dies kann sowohl bei dem Abstützelement als auch bei den elektrischen Anschlusselementen der Fall sein, wobei die Abbiegung vorteilhaft jeweils rechtwinklig vorgesehen sein kann.

Die Anschlusselemente können jedoch auch als streifenförmige Leiter ausgebildet sein. An den Enden der Leiter können anstelle von abgebogenen Drahtenden auch verbreiterte metallische Pads vorgesehen sein, ähnlich denen, die auf den entsprechenden Leiterplatten vorgesehen sind. Das Auflöten der Auflagebereiche auf meist runde Pads der Leiterplatte erfolgt aufgrund der Oberflächenspannung des verwendeten verflüssigten Lötzinns zentrierend. Diese Wirkung wird noch verstärkt, wenn auch die Auflagebereiche des Bauteiles als runde Pads ausgebildet sind.

Weiterhin kann das Abstützelement unmittelbar an dem induktiven Element befestigt werden kann. Dies hat den Vorteil, dass die Positionierung der elektrischen Anschlüsse und Auflagebereiche des induktiven Elementes relativ zu dem Abstützelement festliegen und stabil sind.

Alternativ kann auch vorgesehen sein, dass das Bauteil ein mit dem induktiven Element verbundenes Stabilisierungselement aufweist. Ein solches Stabilisierungselement kann beispielsweise ein Gehäusekörper oder eine mit dem induktiven Element verbundene Vergussmasse oder ein anderer stabilisierender Körper, beispielsweise eine Platte sein, an die das induktive Element angeklebt ist. Derartige Stabilisierungselemente können einerseits zum Schutz des induktiven Elementes auf der Leiterplatte dienen, andererseits auch dazu, das induktive Element transportfähig zu machen und bei der SMT-Montage gegen äussere Einflüsse abzuschirmen, da manche induktive Elemente derart labil sind, dass sie des mechanischen Schutzes bedürfen.

Das Bauteil kann beispielsweise ein Gehäuse aus einem leitenden Werkstoff aufweisen, wobei der Werkstoff beispielsweise als pulvermetallischer Werkstoff durch Pressen beziehungsweise Sintern verarbeitet sein kann und zudem auch weichmagnetische Eigenschaften aufweisen kann. In diesem Fall kann das Material des Gehäuses auch magnetische Eigenschaften in Verbindung mit dem induktiven Element übernehmen.

Die leitende Eigenschaft des Werkstoffs kann dazu dienen, das induktive Element abzuschirmen beziehungsweise auch mittels des Abstützelementes das Gehäuse auf Erdpotential zu legen.

Zudem kann das Stabilisierungselement eine Vergussmasse aufweisen, in die das induktive Element eingebettet ist. Die Vergussmasse kann allein als Stabilisierungselement vorgesehen sein oder ihrerseits von dem Gehäuse umgeben sein.

Auch die Vergussmasse kann beispielsweise aus einem weichmagnetischen Werkstoff bestehen, um bei der Funktion des induktiven Elementes mit diesem, insbesondere wenn es sich um eine Spule handelt, in gewünschter Weise zusammenzuwirken.

In allen genannten Fällen kann das Abstützelement beispielsweise an dem Gehäuse befestigt oder mit diesem sogar einstückig verbunden sein und aus dem selben Material wie dieses bestehen. Das Abstützelement kann beispielsweise auch in einem einzigen Herstellungsschritt gemeinsam mit dem Gehäuse hergestellt sein.

Das Abstützelement kann jedoch auch teilweise in die Vergussmasse eingegossen und auf diese Weise mit dem induktiven Element verbunden sein oder eines der Teile des Stabilisierungselementes kann eine Aufnahme zur Befestigung und Positionierung des Abstützelementes aufweisen, in die dieses einführbar und in der es beispielsweise durch Verkleben fixierbar ist.

Es kann dies beispielsweise einfach eine Bohrung in der Vergussmasse oder im Gehäuse sein, in die ein Stift des Abstützelementes einsteckbar ist.

Vorteilhaft ist die Anwendung der Erfindung bei einer Spule, beispielsweise einer Luftspule. In diesem Fall kann das Stabilisierungselement einen Schalenkern aus einem weichmagnetischen Material aufweisen, der die magnetischen Flusslinien der Luftspule in gewünschter Weise beeinflusst.

Um diese Wirkung noch zu verstärken, kann der Schalenkern einen das induktive Element durchsetzenden Butzen aufweisen. Der Schalenkern ist vorteilhaft mehrteilig ausgebildet, so dass er nach der Bereitstellung des induktiven Elementes um dieses herumgelegt werden kann.

Die Erfindung bezieht sich auch auf eine Anordnung aus einer elektrischen Leiterplatte und einem induktiven SMD-Bauteil, wobei zumindest die elektrischen Anschlüsse des induktiven Elementes mit der Leiterplatte durch SMT-Technologie verlötet sind, wodurch eine elektrische und mechanische Verbindung geschaffen ist.

Ein Abstützelement kann entweder unverlötet auf der Leiterplatte aufliegen, wobei es während des Montagevorgangs durch seine Abstütz- und Positionierungswirkung für eine positionsgenaue Fixierung des Bauteiles sorgt oder das Abstützelement kann ebenso wie die elektrischen Anschlüsse des induktiven Elementes mit der Leiterplatte verlötet sein und so für eine zusätzliche Stabilisierung der Verbindung sorgen. Zusätzlich kann das Abstützelement, wie oben erwähnt, auch bewirken, dass das Gehäuse als Teil des Stabilisierungselementes mit einem bestimmten gewünschten Potential verbunden wird.

Die Erfindung wird nachfolgend anhand der in den Figuren dargestellten Beispiele näher erläutert. In den Figuren bezeichnen, sofern nicht anders angegeben, gleiche Bezugszeichen gleiche Bauteile mit gleicher Bedeutung. Es zeigt
- Figur 1: ein induktives Element in Form einer Luftspule,
- Figur 2: eine Luftspule in einem durchbrochen dargestellten Gehäuse,
- Figur 3: eine Luftspule, die in einem Gehäuse vergossen ist mit zwei herausragenden Anschlüssen in herkömmlicher Anschlusstechnik,
- Figur 4: ein Bauteil wie das der Figur 3 mit Anschlusspinnen über einer Leiterplatte mit Bohrungen,
- Figur 5: eine Luftspule mit einem zusätzlichen Abstützelement,
- Figur 6: eine Luftspule mit einem zusätzlichen Abstützelement in einem durchbrochen dargestellten Gehäuse,
- Figur 7: ein Bauteil, bei dem ein induktives Element in einem Gehäuse vergossen ist mit rechtwinklig abgebogenen elektrischen Anschlüssen und einem Abstützelement,
- Figur 8: eine Ausnehmung in einem Gehäuse zur Führung eines elektrischen Anschlusses oder Abstützelementes
- Figur 9: ein Bauteil über einer Leiterplatte, die auf ihrer Oberfläche Lötpads aufweist,
- Figur 10: einen Teil eines Gehäuses für eine Luftspule, das einen Schalenkern mit Butzen aus einem weichmagnetischen Material bildet, wobei in dem Butzen eine Öffnung zur Aufnahme eines Abstützelementes vorgesehen ist,
- Figur 11: ein Gehäuse ähnlich dem aus Figur 10, wobei eine Aufnahme für ein Abstützelement in der Gehäusewand vorgesehen ist,
- Figur 12: ein Gehäuse ähnlich dem aus den Figuren 10 und 11, wobei ein Abstützelement teilweise um den Butzen herumgelegt ist,
- Figur 13: ein Gehäuse ähnlich dem aus den Figuren 10, 11 und 12, wobei in die Gehäusewand ein Abstützelement einstückig integriert ist.

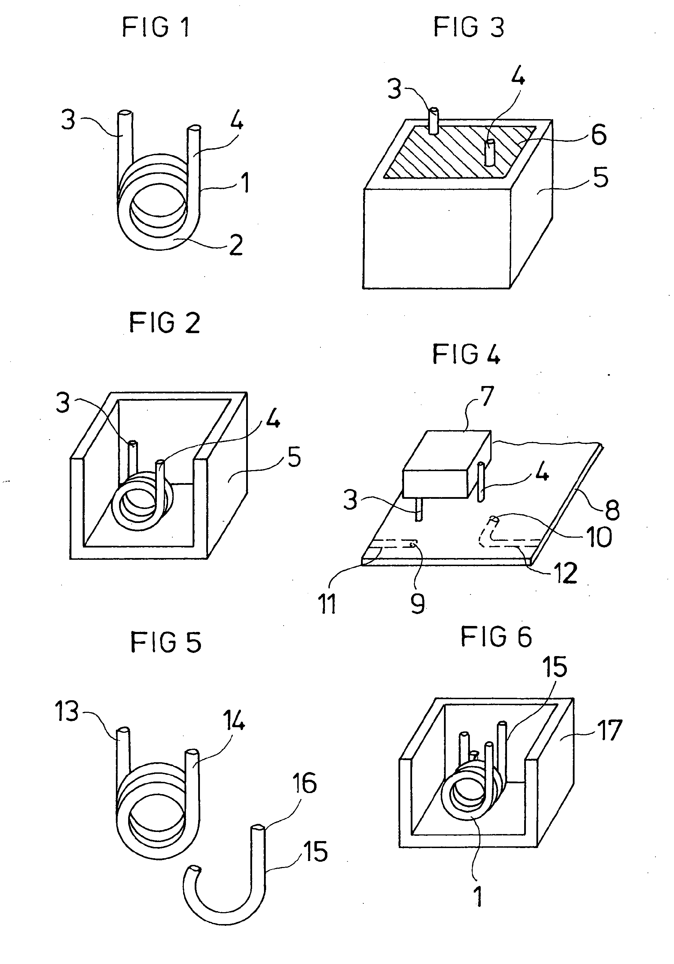

Figur 1 zeigt als Beispiel für ein induktives Element 1 eine elektrische Spule, die aus einem einfachen Leiter 2 mit mehreren Windungen und zwei elektrischen Anschlüssen 3, 4 besteht, jedoch keinen Kern aus magnetisch aktivem, beispielsweise weichmagnetischem, Material hat, was allgemein auch als Luftspule bezeichnet wird.

Derartige Spulen können als induktive Elemente in eine Vergussmasse eingebettet beziehungsweise in einem Gehäuse sowohl als klassische elektronische Bauteile für die PTH-Technik (pin through hole) als auch als SMD-Bauteile hergestellt werden.

Figur 2 zeigt eine Spule, wie sie in Figur 1 dargestellt ist, in einem Gehäuse 5, in das die Spule beispielsweise eingeklebt oder eingegossen wird, derart dass die elektrischen Anschlüsse 3, 4 herausragen. Das Gehäuse kann beispielsweise aus einem Isolierstoff bestehen, um die Spule elektrisch zu isolieren, alternativ auch aus einem leitenden Werkstoff, so dass das Gehäuse beispielsweise auf Erdpotential gelegt werden kann.

In der Figur 3 ist das Bauelement aus Figur 2 vergossen gezeigt, wobei ein Vergusswerkstoff 6 schraffiert dargestellt ist.

Sowohl das Material des Gehäuses 5 als auch der Vergusswerkstoff können besondere magnetische Eigenschaften besitzen, beispielsweise weichmagnetisch sein. Damit können die Eigenschaften des induktiven Elementes, soweit es sich um ein induktives Element wie im vorliegenden Beispiel handelt, gezielt beeinflusst werden. Das Gehäuse 5 kann beispielsweise aus einem pulvermetallurgischen Werkstoff durch Pressen beziehungsweise Sintern hergestellt sein.

Figur 4 zeigt ein elektronisches Bauteil 7 mit einem induktiven Element 2 in Form einer Spule, aus dem die elektrischen Anschlüsse 3, 4 herausragen, wobei das Bauteil 7 über einer Leiterplatte 8 schwebend dargestellt ist. Die Leiterplatte 8 entspricht der klassischen, konventionellen PTH (pin through hole)-Technik und weist Bohrungen 9, 10 zur Aufnahme der elektrischen Anschlüsse 3, 4 auf. Auf der Unterseite der Leiterplatte sind Leiterbahnen 11, 12 vorgesehen, mit denen durch Verlötung auf der Unterseite die elektrischen Anschlüsse 3, 4 verbunden werden.

Ein induktives Bauteil, wie dies in den Figuren 1 bis 4 dargestellt ist, könnte prinzipiell auch als SMD-Bauteil hergestellt werden. Eine Voraussetzung ist, dass die Anschlüsse 13, 14 derartige Auflagebereiche aufweisen, die die Anlage an die Oberfläche einer elektrischen Leiterplatte zum Zwecke der Verlötung erlauben.

Dabei ergibt sich das Problem, dass das SMD-Bauteil zunächst auf der Leiterplatte positioniert werden muss, bevor die eigentliche Verlötung stattfindet. Zwar kann das Bauteil zunächst angeklebt oder mittels einer Lötpaste fixiert werden, jedoch bleibt eine gewisse Unsicherheit, dass das Bauteil durch Kippen seine Position verändert. Dies ist speziell dann ein Problem, wenn nur zwei elektrische Anschlüsse vorhanden sind, die naturgemäß in einer Linie liegen und keine Montagefläche aufspannen, beispielsweise bei einer Spule. Aber auch bei mehr als zwei elektrischen Anschlüssen können diese in einer Linie oder nah beieinander liegen, so dass ein zusätzliches Abstützelement gemäß der Erfindung die vorteilhafte Wirkung einer besseren Abstützung hat. Das Abstützelement wird derart relativ zum induktiven Element beziehungsweise den übrigen Auflagebereichen positioniert werden, das eine Montagefläche aufgespannt wird.

Im vorliegenden Fall werden sowohl die elektrischen Anschlüsse 13, 14 als auch das in der Figur 5 mit 15 bezeichnete Abstützelement, das in einen Anschlussdraht 16 endet, zur Ausbildung von Auflagebereichen rechtwinklig abgebogen. Die elektrischen Anschlüsse 13, 14 und das Abstützelement 15 können aus Lackdrähten bestehen, wobei die Drahtenden der elektrischen Anschlüsse (13, 14) und des Abstützelementes 15 vorteilhaft entweder abisoliert oder abisoliert und verzinnt ausgeführt sind. Als Materialien für die Anschlussdrähte kommen Cu, Cu-Legierungen wie beispielsweise CuSn₆ oder andere leitende Materialien in Frage.

In der Figur 6 sind das induktive Element 1 und das Abstützelement 15 zusammen in einem Gehäuseteil 17 dargestellt, das wiederum zusammen mit einem weiteren, beispielsweise spiegelsymmetrisch angefügten Gehäuseteil 17a ein Gesamtgehäuse zur Aufnahme des induktiven Elementes 1 und des Abstützelementes 15 bildet.

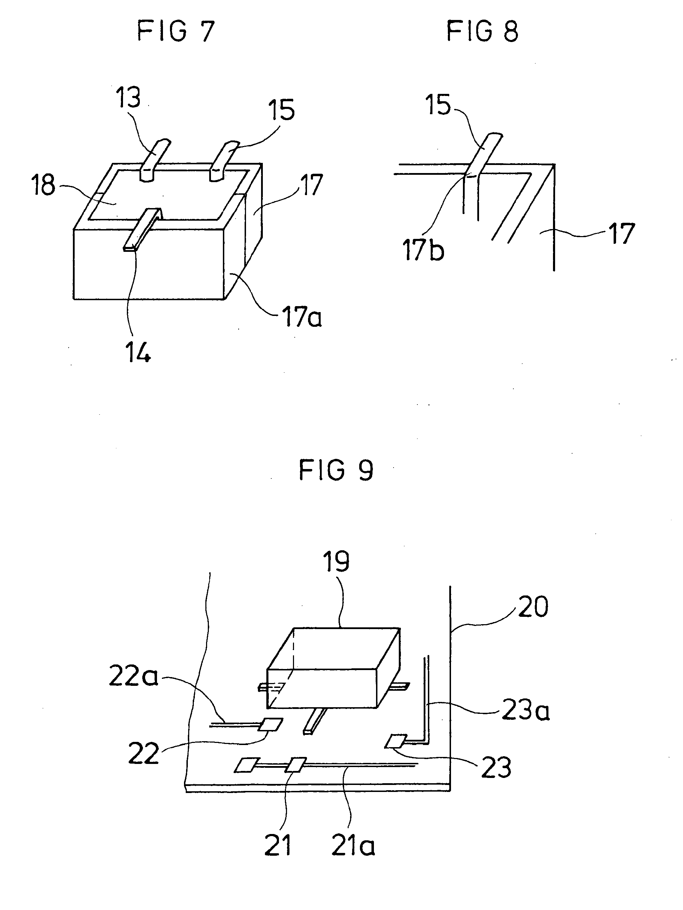

Ein derartiges Bauteil im bereits fertig vergossenem Zustand ist in der Figur 7 dargestellt, wobei dort bereits die Auflagebereiche durch rechtwinkliges Abbiegen der Anschlüsse 13, 14 und des Abstützelementes 15 gebildet sind. Die elektrischen Anschlüsse 13, 14 und das Abstützelement 15 verlaufen gebogen an den Kanten der offenen Seite des Gehäuses 17 von dem induktiven Element 1 wegführend in der Montageebene. Zur mechanischen Unterstützung der elektrischen Anschlüsse 13, 14 und des Anschlusselementes liegen die in die Montageebene gebogenen Enden der elektrischen Anschlüsse 13, 14 und des Abstützelementes 15 an dem Gehäuse 17, 25 an. Alternativ können die elektrischen Anschlüsse 13, 14 und das Abstützelement 15 auch gebogen zu dem induktiven Element 1 hinführend in der Montageebene, zum Beispiel als J-geformte Elemente (J-leads) verlaufen. Kombinationen aus zu dem induktiven Element 1 hinführenden und von dem induktiven Element 1 wegführenden elektrischen Anschlüsse 13, 14 und dem Abstützelement 15 sind ebenfalls möglich. Das Vergussmaterial 18 füllt das Gehäuse 17, 17a nicht ganz aus, so dass eine Behinderung durch das Vergussmaterial 18 beim Aufsetzen des Bauteiles auf eine Leiterplatte ausgeschlossen werden kann. Als Vergussmaterialen eignen sich beispielsweise Epoxi, Pur oder Silikon. Auch andere Materialien sind möglich.

In Figur 8 ist eine Ausnehmung 17b im Gehäuse 17 dargestellt, in der ein gebogenes Abstützelement 15 verläuft. Die Ausnehmung 17 bewirkt zusätzlich zu der in Figur 7 gezeigten Führung durch die Kanten des Gehäuses 17 eine Führung des Abstützelement 15 in der Ebene der offenen Seite des Gehäuses 17. Die Ausnehmung 17b ist offen ausgeführt in Richtung der Normalen auf der Ebene der offenen Seite des Gehäuses 17 von dem induktiven Element 1 (nicht dargestellt) wegführend. Im Querschnitt kann die Ausnehmung 17b eine im wesentlichen runde oder halbrunde Form aufweisen. Durch den Verlauf des Abstützelementes 15 unterhalb der Gehäusekante befindet sich das Abstützelement 15 nicht außerhalb des Gehäuses 17. Bei Verlauf auch der elektrischen Kontakte 13, 14 (nicht dargestellt) in Führungen 17b kann das Gehäuse 17 plan auf der Montagefläche aufliegen.

Die drei abgewinkelten Auflagebereiche der elektrischen Anschlüsse und des Abstützelementes spannen eine Montagefläche auf, die unterhalb des Gehäuses liegt und der Leiterplatte zugewandt ist. Dies ist deutlicher in der Figur 9 dargestellt, wo ein Bauteil 19 mit entsprechend ausgebildeten elektrischen Anschlüssen und einem Abstützelement über einer Leiterplatte 20 schwebend gezeigt ist. Auf der Leiterplatte 20 befinden sich Lötpads 21, 22, 23, auf die beim Herstellungsprozess beispielsweise mittels eines Siebdruckverfahrens Lötpaste aufgebracht wird, bevor das Bauteil 19 aufgesetzt wird. Danach wird die Anordnung zumindest kurzzeitig erhitzt, so dass die Lotkügelchen in der Lötpaste schmelzen und eine Lotverbindung zumindest im Bereich der elektrischen Anschlüsse hergestellt wird. Auch das Abstützelement kann zur Erhöhung der Abstützwirkung verlötet werden.

In der Figur 9 sind auf der Leiterplatte 20 auch Leiterbahnen 21a, 22a, 23a gezeigt, die auf der dem Bauteil zugewandten Seite der Leiterplatte angeordnet sind. Dies hat zur Folge, dass auf der Unterseite der Leiterplatte 20 eine ähnliche Anordnung mit weiteren Bauteilen zusätzlich angeordnet werden kann. Das erfindungsgemäße Vorsehen eines Abstützelementes 15 unter dem Bauteil 19 hat zur Folge, dass das Bauteil dauerhaft und sicher auf der Leiterplatte 20 positioniert werden kann. Für eine stabile Positionierung können unter dem Bauelement 15 auch mehrere Abstützelemente neben den elektrischen Anschlüssen angebracht sein.

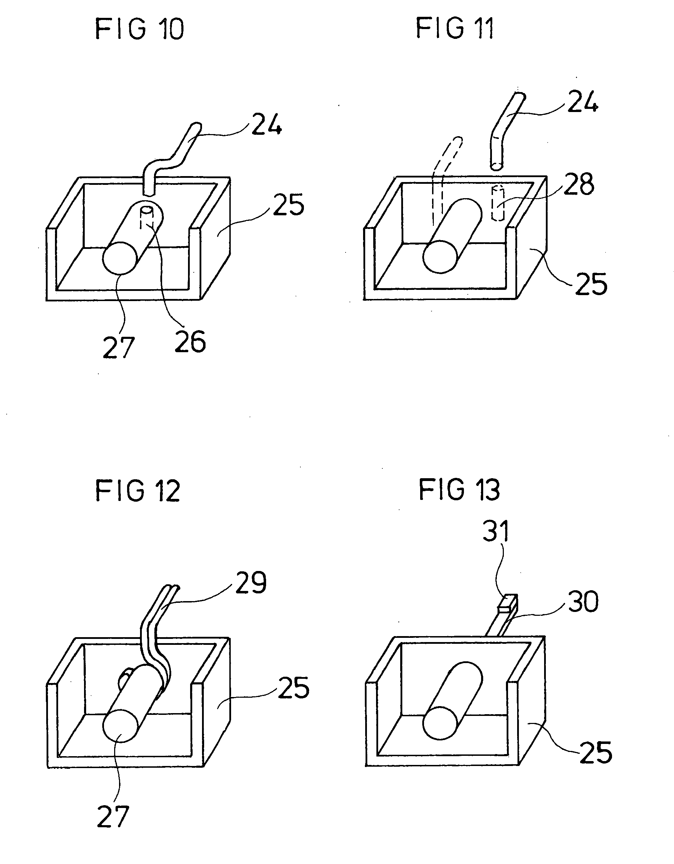

In der Figur 10 ist eine Variante gezeigt, die die Befestigung eines Abstützelementes 24 an einem Gehäuse 25 mittels einer Aufnahmebohrung 26 zeigt. Die Bohrung 26 ist in einem Butzen 27 vorgesehen, der mit dem Gehäuse 25 einstückig verbunden sein und ebenfalls aus einem weichmagnetischen Material bestehen kann. Durch das Einschieben des Abstützelementes 24, das über ein abgebogenes Ende verfügt, wird dieses zuverlässig gegenüber dem (nicht dargestellten) induktiven Element positioniert und kann danach mit vergossen werden. Es kann jedoch auch eine entsprechende Aufnahmebohrung in dem Vergussmaterial eingebracht sein, so dass das Abstützelement 24 nachträglich eingesteckt werden kann. Das Abstützelement 24 kann beim Einstecken zusätzlich mittels eines Klebers fixiert werden.

Um zu vermeiden, dass besonders im Bereich des Butzen 27 durch das Einstecken eines Abstützelementes 24 möglicherweise magnetische Eigenschaften geändert werden, kann eine entsprechende Aufnahme 28, wie in der Figur 11 dargestellt, auch in einer Gehäusewand des Gehäuses 25 angeordnet sein.

Das Abstützelement 29 der Figur 12 kann vorteilhaft mit einer Schlaufe, die auf den Butzen 27 aufgeklemmbar ausgeführt ist, an dem Gehäuse 25 befestigt werden. Das Abstützelement 29 kann beispielsweise durch einen zu einer Schleife zusammengebogenen Draht gebildet sein. Dieser wird nach dem Aufschieben auf den Butzen 27 mit dem (nicht gezeigten) induktiven Element zusammen vergossen.

In der Figur 13 ist dargestellt, dass das Abstützelement 30 direkt mit dem Gehäuse 25 einstückig verbunden ist. Das Abstützelement 30 kann als Steg mit einem angekröpften Kopf 31 direkt mit dem Gehäusematerial 25 verpresst sein. Das Gehäusematerial 25 kann auch ganz oder partiell lötbar sein, um auf diese Weise das Abstützelement 30 an dem Gehäuse befestigen zu können. Die rechtwinkligen Abbiegungen der elektrischen Anschlüsse 3, 4, 13, 14 sind dann derart ausgeführt, dass der abgekröpfte Kopf 31 des Abstützelementes 30 in einer Montagefläche liegt, die vorteilhaft parallel zur Unterseite des Gehäuses 25 ist.

Durch die vorliegende Erfindung wird ohne großen konstruktiven Aufwand die Bestückung von SMT-Leiterplatten vereinfacht und SMD-Bauteile sind einfacher und mit geringerer Verlustrate als bisher einzusetzen.

## Patentansprüche

1. Induktives SMD-Bauteil (19) mit einem induktiven Element (1) in einem Gehäuse (17, 25), bei dem
das induktive Element (1) zwei elektrische Anschlüsse (13,14) aufweist, die zu einer Seite eines Gehäuses (17, 25) aus dem Gehäuse (17, 25) extern kontaktierbar herausgeführt sind,
das Bauteil (19) zusätzlich zu den elektrischen Anschlüssen (13, 14) mindestens ein relativ zum induktiven Element (1) fixiertes Abstützelement (15, 24, 29, 30) aufweist, und
das von dem induktiven Element (1) wegführende Ende des Abstützelementes (15, 24, 29, 30) mit den aus dem Gehäuse (17, 25) herausgeführten Enden der elektrischen Anschlüsse (13, 14) eine Montagefläche am Gehäuse oder ausserhalb des Gehäuses (17, 25) bildet.

2. Bauteil nach Anspruch 1, bei dem das Abstützelement (15, 24, 29, 30) aus einem verlötbaren Metall besteht.

3. Bauteil nach Anspruch 2, bei dem das Abstützelement (15, 24, 29, 30) ein flexibler, biegbarer Draht ist.

4. Bauteil nach Anspruch 3, bei dem das Abstützelement (15, 24, 29, 30) aus Lackdraht besteht, wobei das Drahtende des Abstützelementes (15, 24, 29, 30) abisoliert oder abisoliert und verzinnt ist.

5. Bauteil nach einem der vorhergehenden Ansprüche, bei demdie elektrischen Anschlüsse (13, 14) Drähte sind und zur Bildung von Auflageflächen in die Ebene der Montagefläche ausserhalb des Gehäuses (17, 25) gebogen sind.

6. Bauteil nach einem der vorhergehenen Ansprüche, bei dem die elektrischen Anschlüsse (13, 14) aus Lackdrähten besteht, wobei die Drahtenden der elektrischen Anschlüsse (13, 14) abisoliert oder abisoliert und verzinnt sind.

7. Bauteil nach einem der Ansprüche 3 bis 6, bei dem das Abstützelement (15, 24, 29, 30) an seinem Ende zur Bildung des Abstützbereichs in die Ebene der Montagefläche ausserhalb des Gehäuses (17, 25) gebogen ist.

8. Bauteil nach einem der vorhergehenden Ansprüche, bei dem das Abstützelement (15, 24, 29, 30) unmittelbar mit dem induktiven Element (1) fest verbunden ist.

9. Bauteil nach einem der vorhergehenden Ansprüche, bei dem das Gehäuse (17, 25) zur Stabilisierung des Bauteiles (19) relativ zum induktiven Element (1) fixiert ist.

10. Bauteil nach einem der vorhergehenden Ansprüche, bei dem das Gehäuse (17, 25) das induktive Element (1) teilweise umschließend ausgebildet ist.

11. Bauteil nach einem der Ansprüche 4 bis 10, bei dem zur mechanischen Unterstützung der elektrischen Anschlüsse (13, 14) die in die Montageebene gebogenen Enden der elektrischen Anschlüsse (13, 14) an dem Gehäuse (17, 25) anliegen.

12. Bauteil nach einem der Ansprüche 3 bis 11, bei dem zur mechanischen Unterstützung des Abstützelementes (15, 29) das in die Montageebene gebogene Ende des Abstützelementes (15, 29) an dem Gehäuse (17, 25) anliegt.

13. Bauteil nach einem der vorhergehenden Ansprüche, bei dem das Gehäuse (17, 25) elektrisch leitendes Material aufweist.

14. Bauteil nach einem der vorhergehenden Ansprüche, bei dem das Gehäuse (17, 25) ein pulvermetallurgisches Material aufweist.

15. Bauteil nach Anspruch 13 oder 14, bei dem das Gehäuse (17, 25) weichmagnetisches Material aufweist.

16. Bauteil nach einem der vorhergehenden Ansprüche, bei dem in das Gehäuse (17, 25) eine Vergussmasse (18) gefüllt ist, in die das induktive Element (1) eingebettet ist.

17. Bauteil nach Anspruch 16, bei dem die Vergussmasse (18) aus einem weichmagnetischen Werkstoff besteht.

18. Bauteil nach einem der vorhergehenden Ansprüche, bei dem das Abstützelement (15, 24, 29, 30) unmittelbar mit dem Gehäuse (17, 25) fest verbunden ist.

19. Bauteil nach Anspruch 18, bei dem das Abstützelement (24 30) mit dem Gehäuse (17, 25) einstückig verbunden ist und aus dem gleichen Material wie das Gehäuse (17, 25) besteht.

20. Bauteil nach Anspruch 16 oder 17, bei dem das Abstützelement (15, 24, 29) zumindest teilweise in die Vergussmasse eingegossen ist.

21. Bauteil nach einem der vorhergehenden Ansprüche, bei demdas Gehäuse (17, 25) eine Vorrichtung (27, 28) zur Befestigung des Abstützelementes (15, 24, 29, 30) aufweist.

22. Bauteil nach einem der vorhergehenden Ansprüche, bei dem das induktive Element (1) eine Spule mit mindestens einer Windung ist und das Gehäuse (17, 25) einen Schalenkern aus einem weichmagnetischen Material aufweist.

23. Anordnung aus einer elektrischen Leiterplatte (20) und dem Bauteil (19) nach einem der vorhergehenden Ansprüche, bei dem
elektrische Anschlüsse (13, 14) eines induktiven Elementes (1) mit Anschlüssen (21, 22, 23) der Leiterplatte (20) verlötet sind und
ein von dem induktiven Element (1) wegführendes Ende eines Abstützelementes (15, 24, 29, 30), das das Bauteil (19) zusätzlich zu den elektrischen Anschlüssen (13, 14) relativ zum induktiven Element (1) fixiert aufweist, an der Leiterplatte (20) anliegt.

24. Anordnung aus einer elektrischen Leiterplatte (20) und dem Bauteil (19) nach Anspruch 23, bei dem das von dem induktiven Element (1) wegführende Ende des Abstützelementes (15, 24, 29, 30) mit der Leiterplatte (20) verlötet ist.
